# EUROPEAN PATENT APPLICATION

(11) **EP 3 438 937 A1**
(43) Date of publication of application: **06.02.2019**
(21) Application number: 17202273.3
(22) Date of filing: 17.11.2017
(51) Int. Cl.: G06T 17/00

(54) **METHOD FOR INTEGRATING PHOTOGRAPHIC IMAGES AND BIM DATA**

(30) Priority: 01.08.2017 GB 201712378
(71) Applicant: Lobster Pictures Limited, Bristol BS1 4ND (GB)
(72) Inventor: ALLEN,, Robert, Bristol, BS1 4ND (GB); HADLEY,, Jonathan, Bristol, BS1 4ND (GB); REDHEAD,, Peter, Bristol, BS1 4ND (GB)
(74) Representative: Gillard, Matthew Paul

(57) **Abstract**

A method for generating an integrated image containing a photographic image of a construction site taken by an on-site fixed-position camera and a building information model (BIM) image generated from BIM data, the method comprising: acquiring (108) a reference image from the on-site fixed position camera; acquiring (206) details of the geometry of the BIM for the site from a BIM server; defining (210) a virtual camera corresponding to the on-site fixed-position camera; storing alignment data, for aligning the virtual camera with the on-site fixed position camera, in a database; and subsequently: acquiring (214) an image from the on-site fixed-position camera; acquiring current BIM data from the BIM server; retrieving the stored alignment data for the virtual camera from the database; creating a BIM image using the current BIM data and the stored alignment data, wherein the BIM image is aligned with the acquired image from the on-site fixed-position camera; and overlaying the created BIM image over the acquired image from the on-site fixed position camera to generate the integrated image

## Description

### Technical Field

The present application relates to a method for integrating photographic images and building information model (BIM) data.

### Background to the Invention

Building Information Modelling (BIM) is the process of creating a digital representation of the physical and functional characteristics of a building. Often a building information model contains a collaborative repository of knowledge, both written and visual, to allow for effective decision making throughout the process of constructing a building, from initial planning to handover and beyond.

There are varying levels of BIM functionality, including: traditional 3D (computer aided design style) models showing width, height and depth; 4D BIM models in which time is added to the three spatial dimensions, allowing changes in the model over time to be visualised; 5D BIM models in which factors such as the cost of materials, features and the like are available; and 6D BIM, which is sometimes used to refer to a complete BIM project containing a repository of all applicable documentation, materials specifications and the like delivered to the end user.

Time lapse photography is a process by which still photographs are taken at intervals and replayed at a faster rate than the rate at which they were taken (e.g. 25 pictures/second), to give the impression that time is passing more quickly than it actually does. Time lapse photography has many applications, including in the construction industry, where cameras are often deployed on construction sites to take photographs at pre-determined times or intervals to facilitate monitoring of progress of construction projects.

A need exists in the construction industry in particular for a mechanism to integrate building information modelling with time lapse imagery to permit visualisation of progress of construction projects against digital plans and to facilitate sharing of graphical visualisations or representations of progress.

Existing BIM software vendor products do not allow for accurate positioning of cameras in order to align the digital imagery from the building information model with photographic imagery captured by the cameras. Thus, using existing vendor software products, each image captured by an on-site camera must be exported, and the collection of images captured must then be manually re-sized and imported into a system to allow them to be aligned and overlaid onto the digital imagery of the site provided by the building information model.

An alternative approach is to export the BIM model as an object-based model (FBX) file and import this into 3D modelling software. Camera alignment is more accurate using this approach, but the process of importing the model and exporting the images captured by the camera and overlaid onto the digital imagery provided by the BIM model is still a manual one.

Accordingly, a need exists for a method for integrating time lapse photography with BIM models accurately and without requiring manual importing, exporting or manipulation of image or model data.

### Summary of Invention

According to a first aspect of the present invention there is provided a method for generating an integrated image containing a photographic image of a construction site taken by an on-site fixed-position camera and a building information model (BIM) image generated from BIM data, the method comprising: acquiring a reference image from the on-site fixed position camera; acquiring details of the geometry of the BIM for the site from a BIM server; defining a virtual camera corresponding to the on-site fixed-position camera; storing alignment data, for aligning the virtual camera with the on-site fixed position camera, in a database; and subsequently: acquiring an image from the on-site fixed-position camera; acquiring current BIM data from the BIM server; retrieving the stored alignment data for the virtual camera from the database; creating a BIM image using the current BIM data and the stored alignment data, wherein the BIM image is aligned with the acquired image from the on-site fixed-position camera; and overlaying the created BIM image over the acquired image from the on-site fixed position camera to generate the integrated image.

The alignment data may be generated by adjusting one or more parameters of the virtual camera.

The one or more parameters may comprise: a position of the virtual camera; an orientation or rotation of the virtual camera; and a field of view of the virtual camera.

The method may further comprise generating an image from the acquired geometry information, which image changes as the parameters of the virtual camera are adjusted, wherein the alignment data is generated by adjusting the one or more parameters of the virtual camera until a feature of the BIM image aligns with a corresponding feature of the reference image.

BIM images may be generated using the current BIM data and the stored alignment data at predetermined times.

The generated BIM images may be stored in an image server.

An image may be acquired from the on-site fixed-position camera at predetermined times.

According to a second aspect of the invention there is provided a computer program which, when executed by executed by a processing system, causes the processing system to perform the method of the first aspect.

### Brief Description of the Drawings

Embodiments of the invention will now be described, strictly by way of example only, with reference to the accompanying drawings, of which:
Figure 1 is a flow diagram illustrating steps in a method for integrating images from a fixed position camera with BIM images; and
Figure 2 is a flow diagram illustrating steps in a method for automatically generating BIM images for integration with fixed position camera images.

### Description of the Embodiments

The methods described herein automate the extraction, importing and regular updating of a time-varying sequence of time-based images from a BIM software package. The images generated by the BIM software package from the BIM model (hereinafter referred to as "BIM images") are aligned to a viewpoint corresponding to a real-world fixed-position camera, to allow them to be overlaid over a photograph taken by the fixed-position camera. Thus, BIM images showing the predicted appearance of a construction site at a particular point in time according to a project plan for a construction project taking place on the construction site can be overlaid with photographic images captured by the fixed-position camera, which is positioned at a fixed location on the construction site, showing actual progress on site at that particular time, thereby allowing the user to make a comparative analysis and visualise the actual progress of their projects against digital plans.

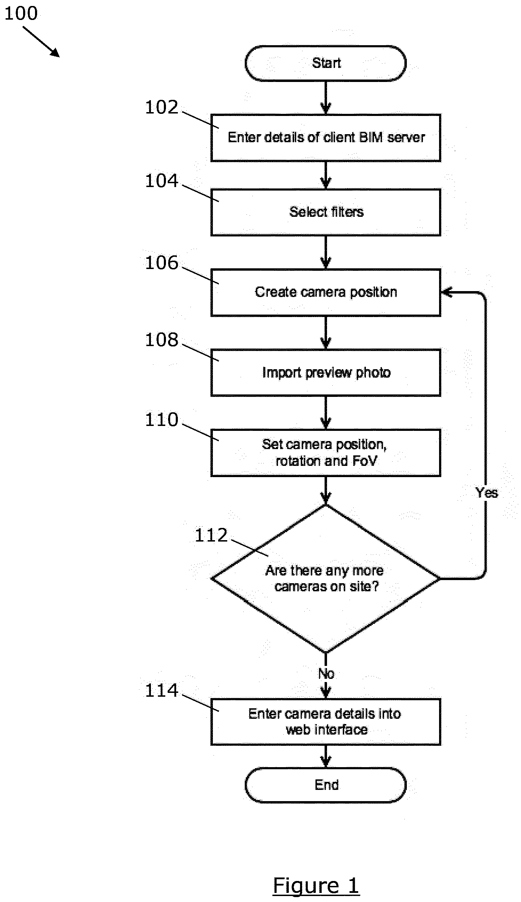

Figure 1 is a flow diagram which illustrates steps in a method for integrating images from a fixed position camera on a construction site with BIM images. The method may be performed, for example, in a software application for viewing images. The application may be provided as a standalone computer program product or application configured to run on a desktop or laptop PC or on a mobile device such as a smartphone or tablet computer, or as a web application that is accessible via the internet using any suitable computing device.

As will be appreciated, any meaningful comparison of BIM images showing the predicted progress of a construction project with photographic images taken by a fixed-position camera on site, by overlaying the BIM images over the photographic images, requires accurate alignment of the viewpoint of the on-site fixed-position camera with the viewpoint of the BIM images generated from the BIM model. Thus, the method includes steps to align the viewpoint from which the BIM images are generated with that of the on-site fixed-position camera.

A first step 102 in the method illustrated generally at 100 in Figure 1 involves providing details of a client BIM server at which all of the BIM data making up the BIM model is stored. These details may be entered manually into a user interface, or may be retrieved and entered automatically by the application.

Filters are created at step 104 to define the data from the BIM model that will be downloaded into the application in order to generate BIM images, and the relevant BIM information is imported to the application.

At step 106 a virtual camera is created in the application, with the position of the virtual camera in the application corresponding to the position of the on-site fixed-position camera. The virtual camera simulates a real camera, in the sense that the virtual camera defines the position, orientation and viewpoint from which virtual images of the site are generated based on the available BIM data (i.e. the BIM images). There may be more than one on-site fixed-position camera (as multiple different views of the site may be required), so steps 106-110 will be repeated for each on-site fixed-position camera.

At step 108, a reference image, which is a photograph taken by the on-site fixed-position camera, is imported into the application.

Subsequently, at step 110, an alignment process is performed to align the virtual camera with the on-site fixed-position camera, by adjusting parameters such as the position of the virtual camera in 3D space, the rotation or orientation of the camera with respect to three mutually orthogonal axes, and the field of view of the virtual camera.

This alignment process may be a manual process performed by an operator, in which a semi-transparent version of the reference image is overlaid over a BIM image generated from the imported BIM model data for the virtual camera. As the parameters of the virtual camera are adjusted, the BIM image changes to reflect the changing position, or orientation/rotation or viewpoint of the virtual camera. When the reference image and the BIM image are aligned to a sufficient degree of accuracy, e.g. when one or more features of the BIM image align with one or more corresponding features of the reference image, the alignment process is complete. Alternatively, suitable image processing techniques may be used to perform this alignment process automatically.

When the alignment process for the first virtual camera is complete, the process is repeated for all on-site fixed cameras, following decision step 112.

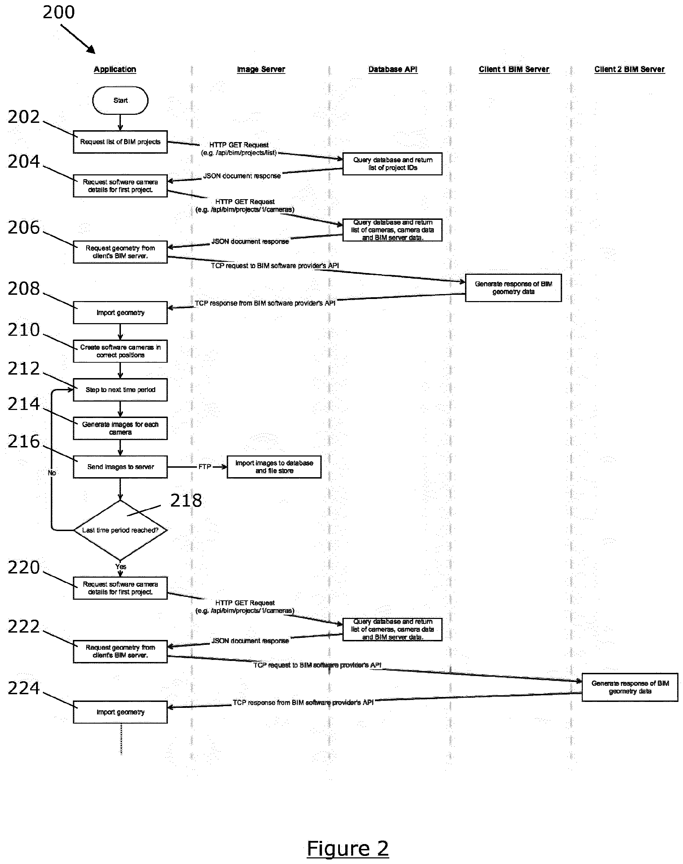

Once all of the virtual cameras have been positioned and aligned with the corresponding on-site fixed-position cameras, the parameters (e.g. position in 3D space, orientation/rotation about three mutually orthogonal axes, field of view) of each virtual camera are stored in a database at step 114. Again, this step may be performed manually by an operator entering the parameters for each virtual camera into a web interface, or may be performed automatically by appropriate software routines. The stored parameters are subsequently used in the generation of BIM images to be overlaid onto photographic images generated by the on-site fixed-position cameras, as will now be described with reference to Figure 2.

Figure 2 is a flow diagram which illustrates steps in a method for automatically generating BIM images at predetermined times or intervals for integration with fixed position camera images. As can be seen, Figure 2 shows steps taken by a software application which generates the BIM images as well as steps taken by an image server, a database API (application programming interface) and BIM servers.

The first step 202 in the method shown generally at 200 in Figure 2 is a request by the application for a list of BIM projects. A GET request is issued by the application to the database API, which in turn queries a database and returns a list of BIM projects for which cameras have been configured.

At step 204, the application requests details of the virtual cameras for the first BIM project. A GET request is issued by the application to the database API, which queries the database and returns a list of the virtual cameras and their parameters for each BIM project for which virtual cameras have been configured, as well as details of the BIM server which stores the BIM data for each BIM project for which virtual cameras have been configured.

At step 206, the application requests geometry data from the BIM server identified by the database API for the first BIM project. A TCP request is issued by the application to the relevant BIM server, which returns the requested geometry data.

The BIM geometry data is imported by the application at step 208. Note that this geometry data is the latest BIM geometry data available from the BIM server. Importing the latest BIM geometry data in this way ensures that the integrated image generated by the application is as up to date as possible, allowing an accurate comparison of actual progress against predicted progress of the project as defined in the BIM information.

At step 210, the application creates one or more virtual cameras in the correct positions, as defined by the virtual camera parameters returned by the database API at step 204.

At step 212, the application steps to the next (or first) of the predetermined times or intervals at which images are to be generated and proceeds to generate at step 214 an image of the site for each of the virtual cameras, based on the BIM geometry data imported in step 208, showing the expected progress of the project. At step 216 these images are sent (via FTP) to the image server for secure storage. Steps 212-216 are repeated for each of the predetermined times or intervals at which images are to be generated, until the last of the predetermined times is reached, as determined by decision step 218.

The method 200 is then repeated for the next BIM project in the list of BIM projects, and thus steps 220, 222 and 224 of the method 200 correspond to steps 202, 204 and 206 for the next BIM project.

The on-site fixed-position camera(s) are programmed to capture photographic images of the site at predetermined times or intervals, which are typically the same as the predetermined times or intervals at which BIM images are generated by the application (but may alternatively be different - for example, the on-site fixed-position cameras may be configured to capture an image of the site every hour, whereas the application may be configured to generate a BIM image of the site for each of the virtual cameras once per day).

The photographic images captured by the on-site fixed-position camera(s) are made available for viewing by a user (e.g. the person or organisation who commissioned the construction work or the lead contractor) through a web interface, for example. A user interface is provided which gives the user the option of overlaying the photographic images captured by the on-site fixed-position cameras over the BIM images generated by the application. If the user selects this option a list of dates and/or times for which BIM images corresponding to the currently selected on-site fixed-position camera are available is presented. Once the user has selected one of the presented dates and/or times, the BIM image corresponding to the selected date and/or time is overlaid onto the photographic image captured by the corresponding on-site fixed-position camera, thereby allowing the user to see the actual progress of the project (as represented by the image captured by the on-site fixed-position camera) and the predicted progress of the project (as represented by the corresponding BIM image generated by the application) in the same image.

The methods described above allow for accurate alignment of BIM images generated from BIM model data with photographic images captured the on-site fixed position cameras. The integration of BIM images and photographic images facilitates the comparative analysis of the progress of a construction project. Further, once the initial alignment of the BIM image data with the photographic image data has been completed, new integrated BIM and photographic images can be generated easily and quickly without any additional configuration being required, and since the method imports the most current BIM data from the client's own BIM server when generating BIM images in accordance with the predefined schedule, these integrated images provide the most up to date visual representation possible of actual progress versus expected progress of a construction project.

## Claims

1. A method for generating an integrated image containing a photographic image of a construction site taken by an on-site fixed-position camera and a building information model (BIM) image generated from BIM data, the method comprising:
acquiring a reference image from the on-site fixed position camera;
acquiring details of the geometry of the BIM for the site from a BIM server;
defining a virtual camera corresponding to the on-site fixed-position camera;
storing alignment data, for aligning the virtual camera with the on-site fixed position camera, in a database; and subsequently:
acquiring an image from the on-site fixed-position camera;
acquiring current BIM data from the BIM server;
retrieving the stored alignment data for the virtual camera from the database;
creating a BIM image using the current BIM data and the stored alignment data, wherein the BIM image is aligned with the acquired image from the on-site fixed-position camera; and
overlaying the created BIM image over the acquired image from the on-site fixed position camera to generate the integrated image.

2. A method according to claim 1 wherein the alignment data is generated by adjusting one or more parameters of the virtual camera.

3. A method according to claim 2 wherein the one or more parameters comprise: a position of the virtual camera; an orientation or rotation of the virtual camera; and a field of view of the virtual camera.

4. A method according to claim 2 or claim 3 further comprising generating an image from the acquired geometry information, which image changes as the parameters of the virtual camera are adjusted, wherein the alignment data is generated by adjusting the one or more parameters of the virtual camera until a feature of the BIM image aligns with a corresponding feature of the reference image.

5. A method according to any one of the preceding claims wherein BIM images are generated using the current BIM data and the stored alignment data at predetermined times.

6. A method according to claim 5 wherein the generated BIM images are stored in an image server.

7. A method according to any one of the preceding claims wherein an image is acquired from the on-site fixed-position camera at predetermined times.

8. A computer program which, when executed by executed by a processing system, causes the processing system to perform the method of any one of the preceding claims.
